## Europäisches Patentamt

(19) **European Patent Office**

**Office européen des brevets**

(11) Veröffentlichungsnummer: **0 036 074**
**B1**

(12) # EUROPÄISCHE PATENTSCHRIFT

(45) Veröffentlichungstag der Patentschrift:
08.08.84

(51) Int. Cl.³: **G 10 H 7/00**

(21) Anmeldenummer: **81100872.1**

(22) Anmeldetag: **07.02.81**

(54) **Syntheseschaltung für periodische Signale, insbesondere als Teil eines Musikinstruments.**

(30) Priorität: **22.02.80 FR 8003892**

(43) Veröffentlichungstag der Anmeldung:
**23.09.81 Patentblatt 81/38**

(45) Bekanntmachung des Hinweises auf die Patenterteilung:
**08.08.84 Patentblatt 84/32**

(84) Benannte Vertragsstaaten:
**AT DE FR GB IT NL**

(56) Entgegenhaltungen:
**US - A - 3 824 385**
**US - A - 3 870 463**
**US - A - 4 043 240**

(73) Patentinhaber: **Deforeit, Christian Jacques, 6, rue de l'Hôpital, D-21140 Semur-en-Auxois (FR)**

(72) Erfinder: **Deforeit, Christian Jacques, 6, rue de l'Hôpital, D-21140 Semur-en-Auxois (FR)**

(74) Vertreter: **Dipl.-Ing. H. Marsch Dipl.-Ing. K. Sparing Dipl.-Phys.Dr. W.H. Röhl Patentanwälte, Rethelstrasse 123, D-4000 Düsseldorf (DE)**

BUNDESDRUCKEREI BERLIN

**Beschreibung**

Die Erfindung bezieht sich auf einen polyphonen numerischen Synthesizer für periodische Signale, insbesondere zur Erzeugung musikalischer Töne, und auf deren Anwendung als Tonerzeugungssystem eines Musikinstruments.

Die Erfindung geht aus von einer bekannten Syntheseschaltung, bei der jeder einem Ausgangskanal zugeführte analoge Abtastwert eines zu erzeugenden periodischen Signals erhalten wird durch Ableitung aus einer Anzahl numerischer Daten bezüglich der Augenblicksphase, der Oktave und der Amplitude (dies sind die mindestens notwendigen Daten), welche in einer Anzahl von Randomspeichern enthalten sind. Diese Speicher können von einem Steuerkreis aus programmiert werden, vorzugsweise unter Verwendung eines Mikroprozessors, der unabhängig von der eigentlichen Syntheseschaltung arbeitet. Dieser Stand der Technik wird belegt durch FR-A-2 396 375, EP-0 011 576 und EP 0 021 964.

Bei den bekannten Syntheseschaltungen ist die Zahl der Grundfrequenzen begrenzt. Als Grundfrequenz soll hier eine Frequenz bezeichnet werden, von der ausgehend weitere Frequenzen ableitbar sind, im allgemeinen durch fortlaufende Teilung (Oktaven). Alle Frequenzen der Syntheseschaltung werden üblicherweise von Oszillatoren (mindestens 12 bei chromatischer Stimmung) abgeleitet, deren Zahl jedoch begrenzt ist; diese Gruppe von Oszillatoren kann auch durch einen einzigen Oszillator mit nachgeschalteten Teilerschaltungen ersetzt sein. Um jedoch bestimmte komplexe Geräusche zu erzeugen, wird es erforderlich, Frequenzen zu Hilfe zu nehmen, die nicht in der Anzahl der zur Verfügung stehenden Frequenzen enthalten sind. Das Hinzufügen von Oszillatoren oder weiteren Teilerschaltungen macht eine solche Syntheseschaltung kompliziert, schwieriger in der Herstellung und entsprechend teurer.

Aufgabe der vorliegenden Erfindung ist es, eine Syntheseschaltung mit den im Oberbegriff des Patentanspruchs 1 genannten Merkmalen zu schaffen, mittels der beliebige Frequenzen in jedem Zeitpunkt erzeugbar sind, ohne daß die Anzahl von Oszillatoren oder Teilerschaltungen erhöht werden muß. Die Syntheseschaltung soll dabei hinsichtlich der Frequenzen steuerbar sein mittels Kommandos, die von äußeren Steuerschaltungen in derselben Weise geliefert werden, wie die übrigen Befehlssignale, d. h. durch einfaches Einschreiben in Speicher.

Die gemäß der Erfindung vorgesehene Lösung dieser Aufgabe ergibt sich durch die im Patentanspruch 1 genannten Merkmale. Dabei soll unter einem Speicherblock eine Gruppe von Speichern verstanden werden, welche alle erforderlichen Daten für die Synthese der analogen aufeinanderfolgenden Abtastwerte eines einzigen Analogsignals oder mehrerer in harmonischer Beziehung stehender Signale enthalten (Grundfrequenz und Oktaven oder Harmonische). Gemäß einer ersten Ausführungsform kann das Erzeugen eines Abtastwertes eine einzige Ausleseoperation erfordern, wobei die Gruppe von numerischen Daten dann unter derselben Adresse zur Verfügung steht, parallel und gleichzeitig. Bei einer anderen Ausführungsform können auch mehrere Auslesevorgänge nacheinander unter unterschiedlichen Adressen erforderlich sein, wobei bestimmte Daten dann in Zwischenregistern gespeichert sind. Beide Ausführungsformen sind zueinander äquivalent, und die Erfindung ist in beiden Fällen anwendbar.

Die Auswahl der Ausführungsform ergibt sich aus der Organisation der Speicherung. Um ein Grundsignal mit zugeordneten Harmonischen zu erzeugen, kann beispielsweise der Datenwert der Phase gemeinsam sein, und zu einem anderen Zeitpunkt ausgelesen werden wie die anderen Daten, um so eine bessere Ausnutzung der Speicher zu ermöglichen.

Ein wichtiger Vorteil der Erfindung ergibt sich aus der Tatsache, daß der dem Taktgeber zugeordnete Zähler, dessen Zählstand als Bezugswert bei allen Vergleichen mit den Ereignisspeichern dient, nur einmal vorhanden zu sein braucht und automatisch inkrementiert wird bei jedem Takt des Taktgebers, also unabhängig von den anderen Teilen der Syntheseschaltung. Er bildet demgemäß eine Zeitbasis, die allen Synthesevorgängen gemeinsam ist.

Ein weiterer Vorteil der Erfindung liegt in der Vielseitigkeit, mit der die Frequenz der erzeugten Signale modifiziert werden kann, insbesondere durch Modifikation des Inhalts des Periodenspeichers durch äußere Steuerkreise. Es ist auch möglich, eine relative Veränderung der Signalphasen relativ zueinander zu erzielen, indem man den Inhalt der Ereignisspeicher verändert. In diesem letzteren Fall jedoch ist die vollständige Steuerung des Inhalts der Ereignisspeicher durch äußere Steuerkreise schwierig und kompliziert.

Demgemäß besteht eine wichtige Weiterbildung der Erfindung im Hinzufügen eines zusätzlichen Speichers, der dazu dient, einen numerischen Datenwert der Modulation zu speichern, wobei Schaltkreise für die automatische Veränderung in Abhängigkeit von der Zeit für die Datenwerte der Periode TE vorgesehen sind, womit man eine automatische Phasenmodulation des Signals erzielt, ausgehend von den Synthesedaten, denen diese Modulationsdaten zugeordnet sind.

Weiterbildungen der vorliegenden Erfindung ergeben sich aus den übrigen Unteransprüchen, wobei die Bedeutung der darin genannten Merkmale sich am besten aus der nachfolgenden Erläuterung von Ausführungsbeispielen entnehmen läßt. Dabei wird auf die Zeichnungen Bezug genommen.

Fig. 1 zeigt ein Blockschaltbild einer Syntheseschaltung gemäß der Erfindung, wobei einerseits die herkömmlichen Steuerschaltkreise mit Basisoszillatoren und andererseits die erfindungsgemäß vorgesehene Schaltkreise dargestellt sind.

Fig. 2 ist ein Blockschaltbild einer Syntheseschaltung gemäß der Erfindung, ergänzt durch Schaltkreise für automatische Phasenmodulation.

Fig. 3 ist ein Beispiel für eine praktische Ausführung der Syntheseschaltung.

Fig. 4 ist eine graphische Darstellung von erzielten Signalen in Abhängigkeit von der Zeit.

Fig. 5 zeigt eine Modifikation der vorbeschriebenen Ausführungsbeispiele, um bestimmte Rauschanteile zu eliminieren, und

Fig. 6 ist ein Zeitdiagramm zur Erläuterung des Verhaltens der Schaltung nach F i g. 5.

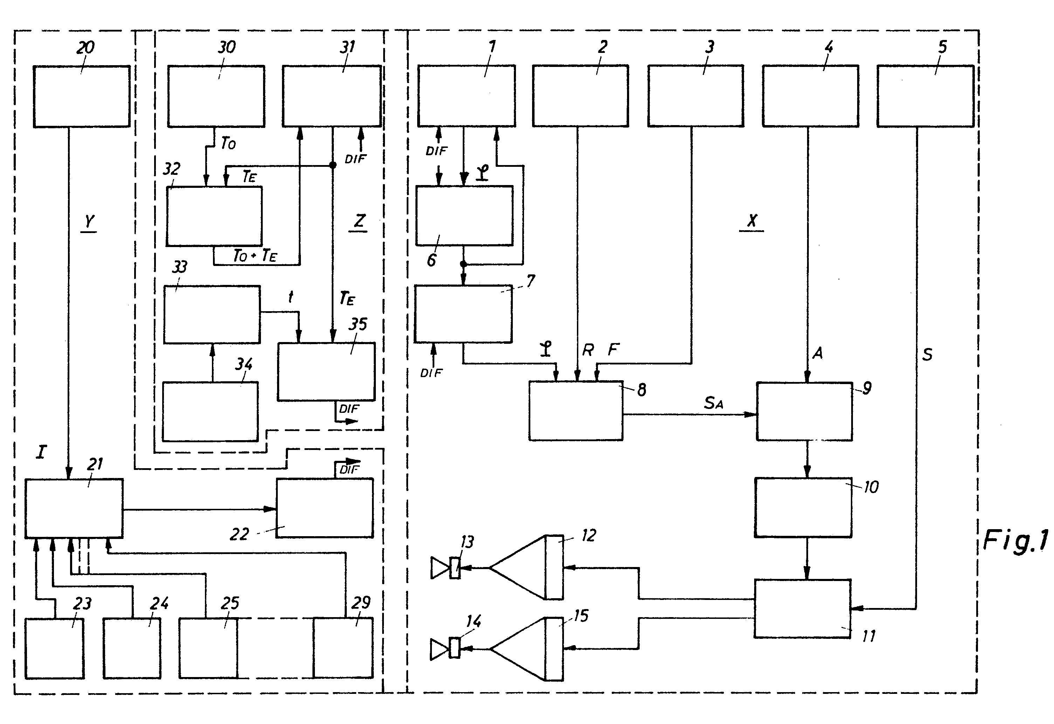

Fig. 1 zeigt das Prinzipschema eines Synthesizers gemäß der Erfindung.

Die Fig. 1 umfaßt drei Abschnitte, die der Deutlichkeit wegen voneinander getrennt dargestellt wurden. Der Abschnitt X umfaßt die Mittel zur Erzeugung der Abtastwerte, das sind die aufeinanderfolgenden Signalelemente, aus denen das zu erzeugende Signal zusammengesetzt werden soll; der Abschnitt Y zeigt erste Steuereinrichtungen für die genannten Mittel, ausgehend von einer Reihe von Oszillatoren oder Teilern, und dieser Abschnitt Y repräsentiert den Stand der Technik; der Abschnitt Z schließlich zeigt einen Steuerschaltkreis gemäß der Definition im kennzeichnenden Teil des Patentanspruchs 1.

Die Beschreibung der Einrichtungen zum Erzeugen der analogen Abtastwerte (Teil X) braucht hier nur summarisch zu erfolgen, da insoweit auf die eingangs genannten Druckschriften verwiesen werden kann.

Der Synthesizer umfaßt im wesentlichen drei notwendige Baugruppen: Die Gesamtheit der Speicherblöcke oder die sogenannte »virtuelle Tastatur«, welche die Parameter enthält, die zur Synthese der gewünschten Signale erforderlich sind; ferner die Schaltkreise zum Erzeugen der Abtastwerte, ausgehend von den Daten, die aus jedem der Speicherblöcke ausgelesen werden; schließlich die Schaltkreise zum Adressieren der Blöcke und zum Steuern der Synthese gemäß einer bestimmten Verkettung.

Es versteht sich, daß jeder von dem Synthesizer erzeugte Ton ein Elementarsignal oder eine Kombination mehrerer Elementarsignale (sinusförmig oder nicht) ist, daß jedes Elementarsignal gewonnen wird durch eine Abfolge von analogen Abtastwerten, die entsprechend gefiltert werden, und daß alle analogen Abtastwerte sequentiell gewonnen werden, d. h. einer nach dem anderen. Es ist ferner zu berücksichtigen, daß die Frequenz der Abtastung jedes Signals hinreichend hoch zu wählen ist, um nicht die Qualität des erhaltenen Signals zu beeinträchtigen.

Die Synthese eines Abtastwertes erfolgt durch den Teil X. Die Parameter, die diesen Abtastwert beschreiben, sind in einem Block der virtuellen Tastatur enthalten. Dieser Block umfaßt:

— den Speicher 1 für die Augenblicksphase $\varphi$ (der gleiche Speicher 1 kann verwendet werden für die Synthese mehrerer Abtastwerte der Signale, die zueinander harmonische Relation haben, wie etwa Grundton und Oktaven).

— den Speicher 2 für die Nummer R der Oktave.

— den Speicher 3 für die Nummer F einer Wellenform.

— den Speicher 4 für die Amplitude A des Signals,

— den Speicher 5 für die Nummer S des analogen Ausgangskanals.

Die Phase $\varphi$ wird in einer Addierstufe 6 inkrementiert, und die neue Phase $\varphi$ wird anstelle der vorhergehenden in den Speicher 1 eingeschrieben sowie in einem Register 7 zwischengespeichert.

Die Phase $\varphi$ aus dem Register 7, die Oktave R und die Nummer F der Wellenform werden zur Bildung einer Adresse kombiniert an einen Wellenformspeicher 8 angelegt. Dieser liefert einen numerischen Abtastwert SA, der mit der Amplitude A in einer Multiplizierstufe 9 multipliziert wird. Der erhaltene numerische Abtastwert wird dann in analoge Form umgesetzt durch einen Umsetzer 10 und dann einem Demultiplexer 11 zugeführt. Der letztere, gesteuert durch die Zahl S, schaltet den endgültigen analogen Abtastwert entweder auf einen ersten Ausgangskanal, bestehend aus Integrator/Verstärker/Filter 12 und Lautsprecher 13, oder auf einen zweiten Ausgangskanal, bestehend aus der Baugruppe Integrator/Verstärker/Filter 15 und Lautsprecher 14.

Der gesamte Syntheseprozeß jedes Abtastwertes wird durch ein Steuersignal »DIF« gesteuert, dessen Folgefrequenz gleich $F_s \cdot N_R \cdot 2^R$ ist, wobei $F_s$ die Frequenz des Grundsignals ist, $F_s \cdot 2^R$ diejenige des zu erzeugenden Signals bei Oktave R ist und N die Zahl der Abtastwerte ist, die pro Signalperiode zu erzeugen sind, wobei das Produkt $N \cdot 2^R$ konstant ist.

Zum Erzeugen des Signals »DIF« und zum synchronen Adressieren des Blocks, der die Informationen der entsprechenden Abtastwerte, die zu berechnen sind, enthält, hat es sich als besonders vorteilhaft herausgestellt, die aufeinanderfolgende Adressierung der Blöcke gemäß einer bestimmten Verkettung (jeder Block enthält die Adresse des folgenden zu adressierenden Blocks) und die Ansteuerung der Oszillatoren (ebensoviele Oszillatoren, wie Grundfrequenzen vorliegen) zu kombinieren.

Der Abschnitt Y der F i g. 1 zeigt eine bekannte Schaltungsanordnung zum Ableiten des Signals »DIF«.

Der die Parameter eines Abtastwertes enthaltende Block umfaßt dabei einen Speicher 20, welcher die Kennziffer I eines Oszillators enthält. Die Kennziffer I wird einem Multiplexer 21 zugeführt mit einer Mehrzahl von Eingängen, die an die Ausgänge von Oszillatoren 23, 24, 25 ... 29 angekoppelt sind. Das von dem ausgewählten Oszillator erzeugte Rechtecksignal wird an einen Flankendetektorschaltkreis 22 angelegt, der bei jedem Pegelwechsel das Signal »DIF« erzeugt.

Zwei Fälle sind möglich, wenn ein Block adressiert wird:

Entweder liefert der Flankendetektor ein Signal »DIF« und ein Abtastwert wird berechnet (mit Inkrementierung der Phase $\varphi$), und danach wird die Adressierung eines anderen Blocks bewirkt, oder es wurde kein Flankenwechsel erfaßt und die Adressierung des folgenden Blocks wird ohne Erzeugung eines Abtastwertes bewirkt.

Der Teil Z der F i g. 1 zeigt, wie gemäß der Erfindung auf andere Weise der Befehl »DIF« abgeleitet werden kann.

Anstelle einer Vielzahl von Oszillatoren ist nur ein einziger Taktgeber 34 vorgesehen, dessen Frequenz $f_T$ bei etwa 1 ... 2 MHz liegt. Der Taktgeber ist an einen numerischen Zähler 33 angekoppelt, dessen Zählstand t demgemäß regelmäßig inkrementiert wird und eine Zeitbasis bildet.

Anstelle eines Oszillatorauswahlspeichers entsprechend dem Speicher 20 enthält der Block hier zwei Speicher. Der eine Speicher 30 hält eine Zahl To, die repräsentativ ist für die Halbperiode des Grundsignals der Frequenz $F_s$, die oben definiert wurde. Der andere Speicher 31 hält eine Zahl TE, die einem Zeitpunkt entspricht, von dem ausgehend ein Abtastwert des Signals zu erzeugen ist.

Bei jeder Adressierung eines Blockes vergleicht ein Komparator 35 den Zählstand t des Zeitzählers 33 mit dem Inhalt TE des Ereignisspeichers 31.

Es können sich demgemäß wie bei der Ausführungsform nach Abschnitt Y der Fig. 1 zwei Fälle ergeben:

Entweder ist t »vor« TE, und die Adressierung des folgenden Blockes wird bewirkt ohne Erzeugen eines Abtastwertes, oder aber t ist »später« oder gleich TE und ein Signal »DIF« wird erzeugt und hat zur Folge:

—   einerseits die Synthese des entsprechenden Abtastwertes wie oben erläutert (mit Inkrementierung der Phase $\varphi$),
—   andererseits die Addition von To und TE in einer Addierstufe 32 und das Einschreiben des Resultats To + TE in den Speicher 31 auf dem Speicherplatz des bisherigen Wertes TE.

Die Genauigkeit der Repetionsfrequenz, mit der das Signal »DIF« erzeugt wird, hängt von der Anzahl der Bits ab, welche die Größen TE bzw. To wiedergeben, das heißt, von der Kapazität der Speicher 30, 31. Mit $f_T$ als der Taktfrequenz des Generators 34 ergibt sich dann

$$f_{DIF} = \frac{2^k}{To} \times f_T$$

wobei k angibt, um wieviele Stellen — im Binärsystem — t gegenüber To nach links verschoben ist. Deshalb kann man mit den oben erwähnten relativ niedrigen Werten für $f_T$ arbeiten, die gerade hoch genug sein muß, um störenden Jitter in »DIF« zu vermeiden: Eine ganzzahlige Beziehung zwischen $f_T$ und den zu erzeugenden Audiofrequenzen ist nicht erforderlich.

Der Speicher 30 ersetzt einen Oszillator aus der Ausführungsform gemäß Abschnitt Y, wobei jedoch die folgenden Vorteile erzielt werden:

—   Die Speicher 30 und 31 befinden sich in der »virtuellen Tastatur« ebenso wie die übrigen Informationen und sind deshalb zugänglich durch außerhalb des Synthesizers befindliche Steuereinrichtungen. Die von ihnen gehaltenen Daten sind demgemäß veränderlich. Es ist deshalb möglich, die Frequenz eines Signals zu verändern, indem man To verändert. Es ist außerdem möglich, auf TE einzuwirken, um eine Phasenmodulation zu erzielen (relativ zur Phase der anderen Signale). Darüber hinaus ist die Zahl der möglichen Frequenzen nicht mehr begrenzt.

Die Ausdrücke »vor« bzw. »später«, welche das Ergebnis des vom Komparator 35 vorgenommenen Vergleichs charakterisieren, bedeuten jeweils »kleiner« bzw. »größer«. Dies trifft jedoch nur zu, wenn die verglichenen Zahlen nicht begrenzt sind. In der Realität müssen die Werte TE und t begrenzt werden aus Gründen der Abmessungen und Kosten für die Speicher auf Zahlen von 10 Bit (d. h. von 0 bis 1 023 in Dezimalschreibung) beispielsweise. Dies bedeutet, daß die beiden verglichenen Zahlen t und TE als Wert t + 1 024 p bzw. TE + 1 024 p' besitzen, wobei p bzw. p' ganzzahlig sind und gleich sind oder sich höchstens um eine Einheit unterscheiden.

Eine einfache Möglichkeit für die Realisierung des Komparators 35 besteht beispielsweise in der Verwendung eines Subtrahierschaltkreises. Das Signal »DIF« wird erhalten, wenn das Vorzeichen von (t — TE) positiv ist.

Eine andere Möglichkeit zum Erzeugen des Signals »DIF« besteht darin, den Zähler 33 durch einen Abwärtszähler zu ersetzen. Die Information t wird gemäß zu —t. Der Komparator 35 ist dann ein einfacher Addierkreis, an den —t und TE angelegt werden. Das höchststellige Bit, d. h. das Vorzeichen am Ausgang des Addierkreises (Komparator 35) ist gleich 1, wenn TE — t negativ ist (d. h. wenn t »später« als TE liegt) und bedeutet demgemäß das Signal »DIF«.

Es versteht sich, daß die Erfindung nicht auf Synthesizer beschränkt ist unter Verwendung von Speicherblöcken, die in Parallelstruktur organisiert sind. Sie ist in gleicher Weise anwendbar auf Strukturen wie sie in den vorgenannten Druckschriften beschrieben wurden. Ferner ist es möglich, die beiden Verfahren zum Erzeugen des Signals »DIF« zu kombinieren. Bestimmte Blöcke können einen Auswahlspeicher 20 für einen Oszillator enthalten und andere Blöcke können Periodenspeicher 30 und Ereignisspeicher 31 enthalten. In diesem Falle erlaubt ein Auswahlparameter, enthalten in einem zusätzlichen Speicherelement jedes Blocks (ein Bit genügt) die Auswahl der Schaltung gemäß Abschnitt Y oder gemäß Abschnitt Z für die Erzeugung des Signals »DIF«.

Der Synthesizer umfaßt demgemäß Auswahleinrichtungen für das Befehlssignal »DIF«, das entweder von der Baugruppe Y erzeugt wird oder von der Baugruppe Z, abhängig von dem Auswahlparameter; eine solche Ausführungsform ist hier allerdings nicht dargestellt.

Externe Steuereinrichtungen liefern die Periode (oder Halbperiode) der höchsten Oktave der zu erzeugenden Töne an den Synthesizer, und dies unabhängig für jeden Block. Dies erlaubt Töne beliebiger Frequenz zu erzeugen. Es versteht sich, daß die maximale Zahl von Signalen, die von dem Synthesizer erzeugt werden können, von der Speichergröße der virtuellen Tastatur und von der Abtastfrequenz der benutzten Blöcke abhängt.

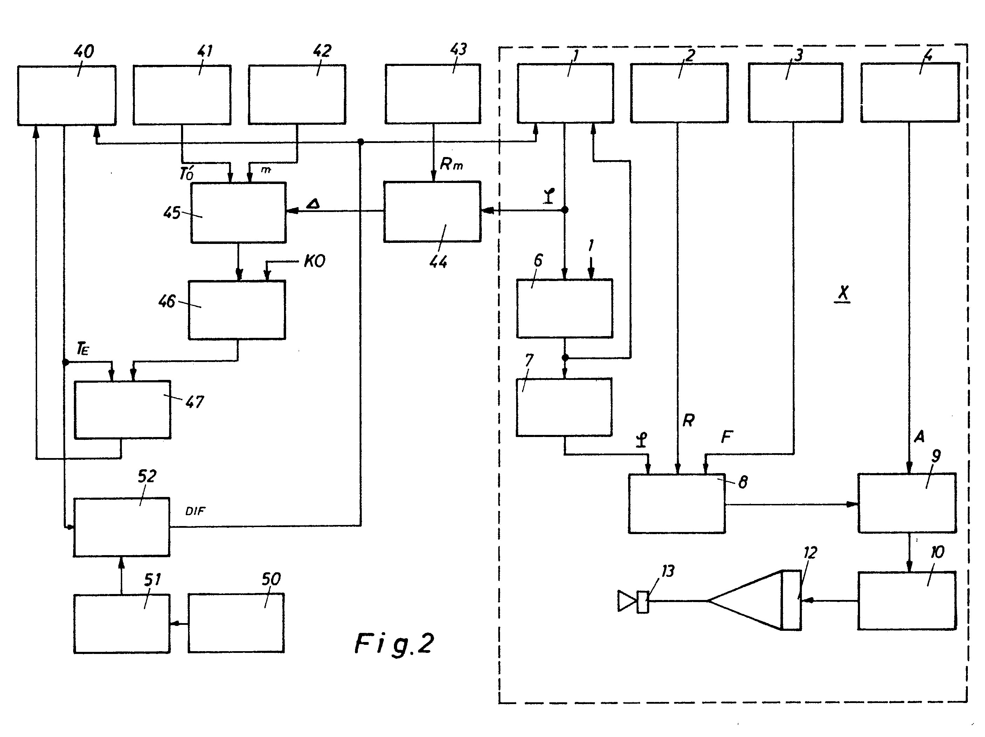

Fig. 2 zeigt einen Synthesizer gemäß der Erfindung, der zusätzlich eine selektive Phasenmodulation bestimmter Signale auszuführen erlaubt.

Wie in Fig. 1 umfaßt der Aufbau die Einrichtungen X für die Abtastwerterzeugung und die Steuereinrichtungen zum Erzeugen des Signals »DIF«. Um die Erläuterung zu vereinfachen, wurde der Abschnitt X mit den gleichen Bezugszeichen wie in Fig. 1 versehen und braucht nicht noch einmal erläutert zu werden.

Der Block der dargestellten virtuellen Tastatur umfaßt neben der Phaseninformation (Speicher 1), der Oktaveninformation R (Speicher 2), dem Typ F der Wellenform (Speicher 3) und der Amplitude A (Speicher 4):

— die Ereigniszeit TE (Speicher 40),
— die Periode T'o (Speicher 41),
— den Modulationskoeffizienten m (Speicher 42),
— die Oktavenauswahl der Modulation Rm (Speicher 43).

Das Ziel besteht nicht darin, eine Frequenzmodulation zu erreichen; der Wert T'o bleibt unverändert, falls nicht eine Veränderung durch externe Steuereinrichtungen vorgenommen wird. Es handelt sich vielmehr darum, eine automatische Phasenmodulation vorzunehmen, die von dem Synthesizer realisiert wird. Diese Modulation wird bei jedem Befehl »DIF« realisiert, indem man auf den Wert einwirkt, der TE ersetzen soll.

Es wurde oben erläutert, daß der Befehl »DIF« die Berechnung und Speicherung eines neuen Wertes von TE einleitet:

neuer Wert von TE = TE + To (To = Periode oder $\frac{1}{2}$ Periode) To kann auf andere Weise ausgedrückt werden:
To = T'o + Ko $\pm$ m wobei (wenn keine Modulation mit m erfolgt) T'o + Ko gleich dem Wert To ist, der in Fig. 1 verwendet wurde und der die Frequenz des Signals definiert.

Ko ist eine Konstante, die systematisch zu allen Werten von T'o durch den Synthesizer hinzugefügt wird, derart, daß die für die Speicherung dieser Werte T'o erforderliche Speicherkapazität verringert wird.

T'o ist jetzt repräsentativ für die Frequenz des Signals.

m ist der Koeffizient oder die Amplitude der Modulation, die entweder hinzugefügt oder abgezogen wird. Dieser Koeffizient, eingespeichert in die virtuelle Tastatur, kann von externen Steuereinrichtungen programmiert werden. Die Addition oder Subtraktion von m erfolgt automatisch durch den Synthesizer bei jedem Kommando »DIF«. Darüber hinaus kann der Zyklus der Additionen und Subtraktionen, d. h. die Modulationsfrequenz, ebenfalls von externen Einrichtungen aus gesteuert werden.

Der Synthesizer umfaßt demgemäß Phasenmodulationseinrichtungen für jedes zu erzeugende Signal, hinsichtlich der Amplitude steuerbar vom Speicher 42 (m) aus und hinsichtlich der Frequenz steuerbar vom Speicher 43 (Rm) aus.

F i g. 2 zeigt im einzelnen ein Beispiel für die Realisierung dieser Phasenmodulation.

Das Vorzeichen + oder —, zugeordnet zu m, wird bestimmt durch den Wert eines Bits der Phase $\varphi$. Zeitlich gesehen stellt dieses Bit ein Rechtecksignal dar. Die Auswahl des Bit wird realisiert durch die Größe Rm im Speicher 43. Der Wert von m muß natürlich kleiner sein als Ko. Der m und Rm enthaltende Block soll als Modulationsblock bezeichnet werden. Die Information Rm dient dazu, ein Bit der Phase auszuwählen (hochgewichtetes Bit, wenn Rm = 0; niedriggewichtetes Bit, falls Rm = 7).

Rm wird an einen Multiplexer 44 angelegt, der vom Speicher 1 das $\varphi$ erhält. Das ausgewählte Bit $\Delta$ steuert einen Addier/Subtrahierkreis 45, der die Informationen T'o vom Speicher 41 erhält und m vom Speicher 42. Das Ergebnis T'o $\pm$ m wird an einen Addierkreis 46 angelegt, der den konstanten Wert Ko hinzufügt.

Der Ausgang dieses Schaltkreises wird an einen weiteren Addierkreis 47 angelegt, der TE vom Speicher 40 empfängt. Der Ausgang von 47 entspricht demgemäß der Summe TE + T'o + Ko $\pm$ m. Wenn das Signal »DIF« vorhanden ist, wird dieser Wert in den Speicher 40 eingeschrieben.

Dieses Signal »DIF« wird wie oben erläutert erzeugt. Ein Taktgeber 50 dekrementiert regelmäßig einen Abwärtszähler 51. Ein Komparator 52, der in Wirklichkeit von einem einfachen Addierkreis gebildet wird, liefert das Signal »DIF« (höchststelliges Bit der Differenz TE — t) einerseits an den TE-Speicher 40 und andererseits an den Phasenspeicher 1 für die Phase $\varphi$.

Da ein Bit der Phase $\varphi$ ein Rechtecksignal beschreibt, ist die Periode der Repetition von Additionen +m gleich der Periode der Repetition von Subtraktionen —m. Die mittlere Periode des erzeugten Signals ist demgemäß T'o + Ko (es liegt keine Frequenzmodulation vor, die man jedoch immer erhalten kann durch externe Steuereinrichtungen, wenn man sie auf T'o einwirken läßt).

Es versteht sich, daß die Modulation der Phase und/oder der Amplitude von Signalen auch auf andere Art möglich sind, und zwar automatisch durch den Synthesizer vorgenommen, ausgehend von Informationen bezüglich dieser Modulation(en) und eingeschrieben in den Block von Speichern mit den anderen Informationen betreffend das zu modulierende Signal.

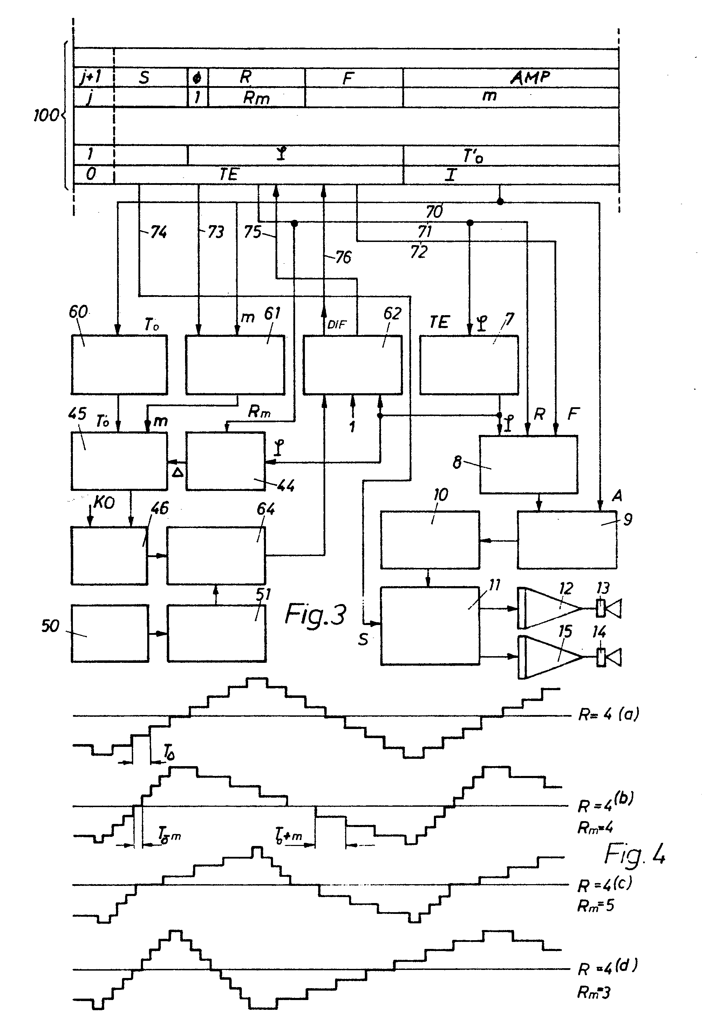

Fig. 3 zeigt ein Beispiel für die Ausführung des Synthesizers, bei dem eine abweichende Organisation der Speicher der virtuellen Tastatur es erlaubt, verschiedene vorbeschriebene Funktionen mit einer verringerten Anzahl von Schaltkreisen auszuführen, indem bestimmte Schaltkreise zusammengefaßt werden.

Wie in den vorhergehenden Figuren werden mit gleichen Bezugszeichen entsprechende gleiche Teile bezeichnet.

Anstatt die jedes Signal betreffenden Daten in einem einzigen Block zu organisieren, der das Auslesen aller dieser Daten »in Parallelform« ermöglicht, sind die Daten auf mehrere Blöcke verteilt, die ein und derselben Gruppe zugehören, jedoch bei unterschiedlichen Adressen, vorzugsweise bei aufeinanderfolgenden Adressen.

Eine solche Organisation des Speichers wurde im einzelnen in der EP-0 011 576 erläutert.

Die Adresse jedes Blocks ist eine Zahl, die aus zwei Teilen besteht. Der erste Teil I bezeichnet die Gesamtheit der Gruppe, und die zweite Zahl N bezeichnet einen Block der Gruppe. Die Adressierung der verschiedenen Blöcke ein- und derselben Gruppe erfolgt nur durch Modifikation des Wertes von N. Jeder Block enthält einen »Sekundärverweis«, worunter der Wert von N eines anderen Blocks zu verstehen ist, was es erlaubt, die Leseoperationen der Blöcke in ein- und derselben Gruppe zu verketten.

Eine Gruppe kann Blöcke zum Erzeugen mehrerer Signale enthalten, wenn diese Signale zueinander in harmonischer Beziehung stehen (beispielsweise eine Grundfrequenz und mehrere Oktaven). Es existieren dann Informationen, die allen Signalen gemeinsam sind, welche in einem oder zwei sogenannten »Hauptblöcken« zusammengefaßt sind; die anderen Informationen befinden sich dann in den »Sekundärblöcken«. Im Zeitpunkt der Adressierung des oder der Hauptblöcke kann dann, wenn die Bedingung t − TE ≥ 0 nicht realisiert ist, der gesamte Rest der Gruppe ignoriert bleiben, und ein »Hauptverweis« erlaubt, eine andere Gruppe zu adressieren.

Die virtuelle Tastatur 100 ist beispielsweise in 16 Gruppen von je 16 Blöcken unterteilt. Nur einer ist in der Zeichnung dargestellt. Dieser umfaßt zwei Hauptblöcke, während die anderen Blöcke Sekundärblöcke sind. Der Deutlichkeit der Beschreibung halber sind die Blöcke mit o, 1, . . . j, j + 1, . . . usw. numeriert.

Der Block 0 ist der erste in der Gruppe adressierte Block. Er enthält die Größe TE (Ereignisdaten) und die Nummer I der folgenden Gruppe.

Der Block 1, der danach nur dann adressiert wird, wenn t ≥ TE, enthält die Augenblicksphase $\varphi$ und die Periode T'o.

Die übrigen Blöcke, also Sekundärblöcke, enthalten die anderen Syntheseinformationen.

Als Beispiel sei der Block j betrachtet, der als Modulationsblock bezeichnet wird; er enthält die Modulationsoktave Rm und den Modulationskoeffizienten m. Der folgende Block j + 1 enthält die Nummer S des Ausgangskanals, die Oktave R, die Wellenform F und die Amplitude AMP des zu erzeugenden Signals.

Jeder Sekundärblock umfaßt ferner ein Element für die Identifikation des Modulationsblocks, hier ein Bit 1 im Modulationsblock, 0 in den anderen Blöcken.

Es versteht sich von selbst, daß dann, wenn eine Gruppe keinen Modulationsblock enthält, die erzeugten Signale nicht moduliert werden und die entsprechenden Modulationsschaltkreise nicht in Betrieb gesetzt werden.

Wie oben ausgeführt, ist die Organisation der Daten in den Speichern derart realisiert, daß die Synthesizerschaltungen gemeinsam verwendbar sind.

Diese Schaltkreise umfassen:

— ein Zwischenregister 7, über das entweder die Phase $\varphi$ oder die Daten TE, ausgelesen in den Hauptblöcken 1 bzw. 0 und übertragen mittels Verbindung 71, laufen,

— einen Wellenformspeicher 8 mit zugehörigen Adressierschaltkreisen, an das die Daten der Phase $\varphi$ vom Zwischenregister 7, der Oktave R des Blocks j + 1 über Verbindung 71 und der Wellenform F des Blockes j + 1 über die Verbindung 72 angelegt werden,

— einen Multiplizierkreis 9, an den der Abtastwert des Speichers 8 angelegt wird sowie die Amplitude AMP aus Block j + 1 über die Verbindung 70,

— einen Digital-Analogumsetzer 10, an die Ausgangsdaten des Multiplizierkreises 9 angelegt werden,

— einen Demultiplexer 11, an den die analogen Abtastwerte vom Umsetzer 10 angelegt werden und der gesteuert wird von den Daten S der Kanalauswahl, geliefert vom Block j + 1 über die Verbindung 74,

— zwei Verstärkungskanäle für tiefe Frequenz, enthaltend jeweils einen Integrationsverstärker 12, 15 und einen Lautsprecher 13, 14, angekoppelt an die Ausgänge des Demultiplexers,

— ein Zwischenregister 60 zum Zwischenspeichern der Daten der Periode T'o, herrührend vom Block 1, über die Verbindung 70,

— ein Zwischenregister 61 zum Empfang des Modulationskoeffizienten m, ausgelesen aus dem Modulationsblock j,

— einen Multiplexer 44, an den als Eingang die Daten der Phase $\varphi$ angelegt werden, ausgelesen am Ausgang des Zwischenregisters 7, und gesteuert von den Daten Rm, ausgelesen aus Block j (Verbindung 71),

— einen Summier/Subtrahierkreis 45, der mit T'o und m aus den Zwischenregistern 60 und 61 beaufschlagt wird und der gesteuert wird von dem Vorzeichenbit $\Delta$, geliefert vom Multiplexer 44,

— einen Addierkreis 46 für den Empfang von Ko und den Ausgangsdaten des Addier/Subtrahierkreises 45. Der Ausgang 46 liefert demgemäß den Wert T'o + Ko ± m.

— einen Taktgeber 50 für die Steuerung eines Abwärtszählers 51, welcher den Zeitmaßstab definiert.

— einen Multiplexer 64 für den Empfang einerseits von T'o + Ko ± m vom Addierkreis 46, andererseits von −t vom Abwärtszähler 51,

— einen Addierkreis 62 zum Empfang der Ausgangssignale vom Register 7 ($\varphi$ oder TE), des Wertes 1, und des Ausgangssignals vom Multiplexer 64 (T'o + Ko + m oder −t). Dieser Addierkreis liefert ein Resultat, das in der virtuellen Tastatur über Verbindung 75 gespeichert werden kann unter Mithilfe des Signals »DIF« über die Verbindung 76.

Der Synthesizer arbeitet wie folgt:

Die virtuelle Tastatur 100 ist in Gruppen unterteilt, die ihrerseits in Blöcke unterteilt sind. Die Adressierung jedes Blocks erfolgt mit Hilfe einer numerischen Adresse, geliefert von einer nicht dargestellten Adressierschaltung. Der erste in der Gruppe I ausgelesene Block hat als Adresse: (I, N = 0). Dieser Block enthält TE und die Nummer I einer folgenden Gruppe. TE wird an den Addierkreis 62 (über den Zwischenspeicher 7) angelegt, und zwar gleichzeitig mit −t (über den Multiplexer 64). Das Signal »DIF« wird demgemäß erzeugt falls TE − t < 0. Im umgekehrten Falle wird nur die folgende Nummer I mittels der Adressierschaltkreise übertragen, und die vorbeschriebenen Operationen wiederholen sich für eine andere Gruppe.

Wenn die Bedingung TE − t < 0 vorliegt, wird der Block N = 1 der Gruppe I adressiert. Die Daten $\varphi$ und T'o werden in den Zwischenregistern 7 bzw. 60 gespeichert. $\varphi$ wird im Addierkreis 62 inkrementiert, und $\varphi + 1$ nimmt den Platz von $\varphi$ in der virtuellen Tastatur ein.

Danach werden die folgenden Blöcke der Gruppe nacheinander adressiert. Diese enthalten jeweils an ihren Enden einen Sekundärverweis, der ausgelesen wird und mittels der Adressierschaltkreis (nicht dargestellt) übertragen wird, wie in der EP-0 011 576 beschrieben. Die auf diese Weise adressierten Blöcke können nicht-modulierende Blöcke sein, wie der Block j + 1. In diesem Falle wird ein Abtastwert berechnet mit Hilfe der gegebenen Daten $\varphi$ (das im Zwischenregister 7 vorliegt), S, R, F und AMP.

Wenn die Gruppe einen modulierenden Block enthält, (der dargestellte Block j), wird die Identifikation 1, die er enthält, über Verbindung 73 zum m-Register 61 übertragen, dort erfaßt und die folgenden Operationen werden gesteuert:

Die Modulationsoktave Rm und der Modulationskoeffizient m werden mit T'o, das in Register 60 gespeichert ist, kombiniert, um T'o + Ko ± m zu bilden, geliefert vom Multiplexer 64. Dieser umfaßt einen Speicher, und am Ende der Berechnung und Erzeugung der Abtastwerte (nicht-modulierende Blöcke) wird erneut der Block (I, N = 0) adressiert und die Größe TE wird ersetzt durch TE + T'o + Ko ± m. Die folgende Größe I erlaubt danach die Adressierung einer anderen Gruppe, und die vorbeschriebenen Operationen können sich automatisch wiederholen.

Fig. 4 zeigt als Beispiel einige Signale, die mit Hilfe der Erfindung gewonnen werden können.

Das Signal (a) ist ein Dreiecksignal, das nicht moduliert ist und charakterisiert ist durch die Oktave R = 4. Es handelt sich um ein treppenförmiges Signal, wobei jede Stufe die Länge $T_0$ besitzt mit $T_0$ = T'o + Ko.

Das Signal (b) ist das gleiche Signal, jedoch einer Phasenmodulation mit dem Koeffizienten $m = \frac{1}{2} T$ unterworfen, mit der Modulationsoktave Rm = 4. Man erkennt eine Betonung der geradzahligen Harmonischen in diesem Falle.

Das Signal (c) ist wiederum dasselbe Signal, das mit demselben Koeffizienten moduliert worden ist, jedoch jetzt mit Rm = 5). Man erkennt demgemäß eine Betonung der ungeradzahligen Harmonischen.

Das Signal (d) ist wiederum dasselbe Signal, das mit demselben Koeffizienten moduliert worden ist, doch ist die Modulationsoktave Rm diesmal kleiner als R (Rm = 3). Man erkennt jetzt das Auftreten der Grundfrequenz bei R = 3.

Die Möglichkeit der automatischen Modulation der erzeugten Signale durch den Synthesizer bietet demgemäß sehr interessante Eigenschaften, die von der Modulationsoktave Rm und der modulierten Oktave R abhängen: Wenn Rm = R, erscheinen die geradzahligen Harmonischen oder werden betont. Wenn Rm > R, erscheinen nur die ungeradzahligen Harmonischen oder werden betont, wenn Rm < R, erscheint eine Grundfrequenz (oder Subharmonische) zur Frequenz R.

Es versteht sich, daß die Bemessung der eingeführten Harmonischen vom Modulationskoeffizienten m abhängt und extern steuerbar ist. Es ist demgemäß möglich, eine Veränderung des Timbre in quasi-kontinuierlicher Weise in Abhängigkeit von der Zeit vorzunehmen, was wichtig ist für eine gute Simulation von nachzuahmenden Instrumenten (z. B. Blechblasinstrumenten, Holzblasinstrumenten). Es ist ebenso möglich, eine automatische Veränderung der Größe m zu erzielen (oder der Größe Rm); entsprechend gilt dies auch für die anderen Größen (ohne Eingriff der externen Steuereinrichtungen), indem man den Synthesizer mit automatischen Interpolationsschaltungen versieht, wie sie in der EP-0 021 964 beschrieben wurden. Diese Interpolation, linear oder exponentiell, kann zeitabhängig erfolgen zwischen dem laufenden Wert der jeweiligen Größe und einem Endwert, der ebenfalls in der virtuellen Tastatur gespeichert ist.

Die Erfindung ist auf Musikinstrumente vom Typ der elektronischen Orgel anwendbar oder bei Bühneninstrumenten oder für die muskalische Forschung. Jedes Instrument kann einen oder mehrere solcher Synthesizer sowie die Steuereinrichtungen umfassen, beispielsweise einen Mikroprozessor und seine zugeordneten Peripherieschaltungen, welche die Abtastung der Knöpfe, Tastaturen und Register und die Eingabe der Daten für die Synthese in die virtuelle Tastatur in Abhängigkeit von einem bestimmten Programm bewirken.

Der Mikroprozessor und seine Peripherieschaltungen bilden die externen Steuereinrichtungen des Synthesizers. Ihre Aufgabe besteht darin, in die virtuelle Tastatur die Größen einzuschreiben, die für die automatische Funktion des Synthesizers benötigt werden. Nach den üblichen Größen für die Synthese ($\varphi$, R, F, AMP, S, T'o, TE, m, Rm, usw.) müssen diese externen Steuereinrichtungen in jeden Block die Adressen (Verweisungsdaten) einschreiben, damit eine korrekte automatische Auslesung der Speicher durch den Synthesizer gemäß einer gewünschten Verkettung erfolgen kann. Natürlich sind die Adressierregister der Blöcke der virtuellen Tastatur nicht dargestellt worden, um die Zeichnungen übersichtlich zu halten, da es sich um eine an sich bekannte Anordnung handelt, die in den eingangs erwähnten Druckschriften beschrieben ist.

Bei jeder Änderung des Zustandes von Registern, Tastaturen und Knöpfen verändern die externen Steuereinrichtungen die in die virtuelle Tastatur eingeschriebenen Daten, um abweichende Töne zu erzeugen.

Diesen Modifikationen können einen oder mehrere Parameter eines Elementarsignals (in einem Block) betreffen, die Hinzufügung oder Unterdrückung von Blöcken innerhalb einer oder mehrerer Gruppen, oder die Hinzufügung oder Unterdrückung einer oder mehrerer Gruppen. Im Falle, in dem die Modifikation sich auf ganze Blöcke oder Gruppen bezieht, genügt eine einfache Modifikation der Speicherverweisdaten, um den gewünschten Effekt zu bewirken.

Es ist klar, daß die Erfindung nicht auf das beschriebene Ausführungsbeispiel beschränkt ist. Ganz allgemein ist es möglich, eine automatische Veränderung beliebiger Parameter der Synthese von Tonsignalen zu erzielen, dank der Schaltungsanordnung gemäß vorliegender Erfindung. Diese Schaltkreise können kombiniert werden mit jenen, die in der EP-0 021 964 beschrieben sind.

Die automatischen Veränderungen der Parameter durch den Synthesizer behindert nicht die Variationen, die von den externen Steuereinrichtungen gesteuert werden. Auf diese Weise ergeben sich enorme Einwirkungsmöglichkeiten auf die erzeugten Tonsignale.

Die insoweit beschriebenen Ausführungsbeispiele zeigen in der Praxis noch eine Eigentümlichkeit, die in bestimmten Fällen stören kann.

Bei jedem Abtastzyklus werden ja die folgenden Operationen ausgeführt:

Eine Ereigniszeit $T_E$ wird durch Subtraktion $T_E - t$ mit dem Wert t verglichen, und wenn $t < T_F$ ist, so bedeutet dies, daß die Ereigniszeit nicht erreicht worden ist und zum nächsten Abtastschritt weitergegangen wird. Ist jedoch $t > T_E$, so wird eine neue Ereigniszeit berechnet, die Phase wird inkrementiert, und die Abtastwerte werden berechnet. Erst dann wird zum nächsten Abtastschritt übergegangen.

Man erkennt jedoch, daß je nach der Länge der I-Liste (das heißt der Anzahl der zu durchlaufenden Programmschleifen) und der Anzahl der zu berechnenden Abtastwerte, diese keineswegs alle in demselben relativen Zeitpunkt innerhalb eines Zyklus erzeugt werden, sondern zu einem Zeitpunkt $T_o > T_E$, wobei die Differenz $T_o$-$T_E$ beinahe statistisch variabel ist. Im Ergebnis enthält das Ausgangssignal einen Anteil an breitbandigem (»weißem«) Rauschen. Dieser Rauschanteil läßt sich jedoch mittels der nachstehend geschilderten Schaltungsvariante unterdrücken.

Die bei $t > T_E$ berechneten Abtastwerte bestehen jeweils aus einer Amplitudeninformation AMP und einer Wellenform-Differenz-Information $\Delta A$. Bei der bisher erläuterten Schaltungsanordnung ergibt sich das Ausgangssignal als $\sum AMP \cdot \Delta A$.

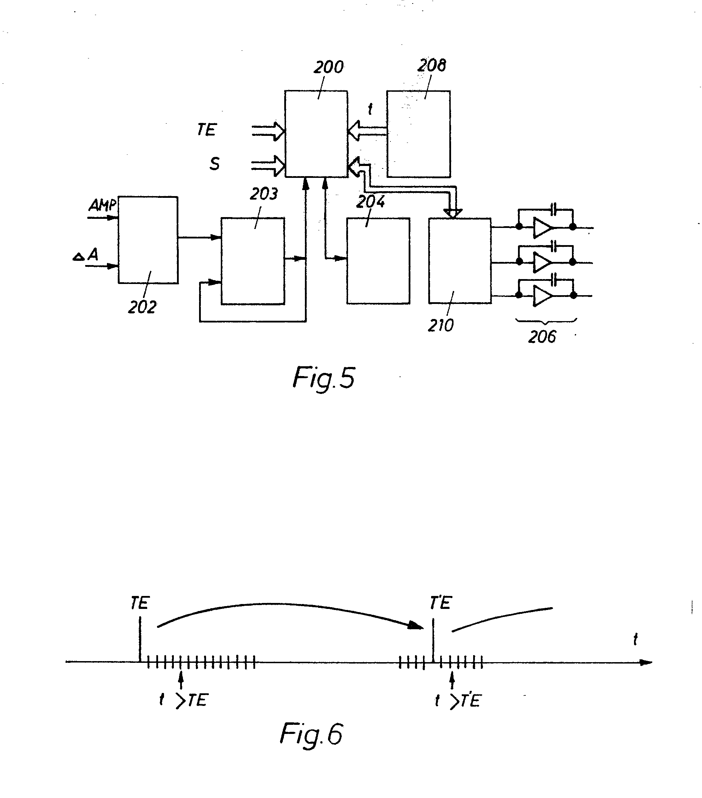

Gemäß der Weiterbildung, deren Ausführungsform unter Bezugnahme auf Fig. 5 und 6 erläutert wird, werden für eine Zeit $T_E$ hier sogenannte »Teilsummen« $S_{TE}$ berechnet, also die $\sum AMP_{TE} \cdot \Delta A_{TE}$. Diese Berechnung erfolgt natürlich zu einem Zeitpunkt, zu dem die Parameter zur Verfügung stehen, also bei $t \geq T_E$. Das Resultat wird aber in einem Zwischenspeicher unter einer Adresse »nächstes $T_E$« eingeschrieben und nicht sofort an die Ausgangskanäle übertragen, sondern mit konstantem Takt zur Realzeit t ausgelesen, einem Digital-Analog-Umsetzer zugeführt und zum Endsignal $\sum S_{TE}$ integriert. Es erfolgt also eine Zeitverzögerung um einen Zyklus, was aber bei musikalischer Anwendung unbedeutend ist.

Fig. 5 zeigt einen Endteil der Schaltung. Der Randomspeicher 200 läßt sich mittels zweier Daten adressieren: Einmal durch $T_E$ vom Synthesizer her für die Einspeicherung, wenn $t \geq T_E$, zum anderen für das Auslesen durch t, geliefert von einem Taktgenerator 208. Nach dem Auslesen wird der entsprechende Speicherplatz gelöscht.

Die zu speichernden Daten sind die Produkte AMP $\cdot \Delta A$. Die Faktoren werden vom Synthesizer geliefert, im Multiplikator 202 miteinander multipliziert und akkumuliert in 203 zum Erzeugen der Teilsumme bezüglich der Zeit $T_E$. Diese Teilsumme $S_{TE}$ wird abgespeichert. Wenn erneut $t \geq T_E$ festgestellt wird, also zum »genauen« Zeitpunkt des nächsten $T_E$, erfolgt das Auslesen der abgespeicherten Teilsumme $T_E$, ihre Übertragung zum Digital-Analog-Wandler 204 und die Übertragung des Analogwertes zum Integrator 206. Dieses Signal enthält kein Jitter mehr.

Die beschriebene Schaltungsanordnung ist besonders geeignet für mehrere Ausgangskanäle, denn eine Schreibadresse S vom Synthesizer kann die Form des Komplements zur $T_E$-Schreibadresse haben. Eine zyklische Kanal-Leseadresse ihrerseits erhält dann zweckmäßig die Form des Komplements der t-Adresse und ermöglicht die Ansteuerung mehrerer Digital-Analog-Wandler oder eines analogen Multiplexers oder einer Kanalweiche 210.

F i g. 6 verdeutlicht den zeitlichen Ablauf: Man erkennt die bezüglich $T_E$ variablen Zeitpunkte, zu denen die Erfassung t ≥ $T_E$ erfolgt, die nachfolgende Teilsummenbildung und die Verschiebung zun nächsten Zeitpunkt $T'_E$.

Es versteht sich, daß die Erfindung bei elektronischen Musikinstrumenten anwendbar ist, die ein oder mehrere Synthesizer aufweisen, wie sie vorstehend beschrieben wurden, wie Orgeln, elektronische Akkordeons oder neuartige Instrumente, bei denen man vorteilhaft von digitaler elektronischer Technik Gebrauch macht.

**Patentansprüche**

1. Polyphone Syntheseschaltung für periodische Signale mit

(a) einer Anzahl von Speicherblöcken mit Speichern (1, 2 . . .), in denen numerische Daten zumindest der Augenblicksphase, der Oktave und der Amplitude von zu erzeugenden analogen periodischen Signalen speicherbar sind,
(b) Mitteln zu Adressieren und Auslesen der Speicherblöcke entsprechend einer vorgegebenen Verkettung,
(c) Mitteln zum Erzeugen analoger Abtastwerte der analogen periodischen Signale aus den aus den Speicherblöcken ausgelesenen Daten in Abhängigkeit von Kommandosignalen (DIF) vorgegebener Wiederholungsfrequenz,

dadurch gekennzeichnet, daß für die Erzeugung der Kommandosignale folgende Mittel vorgesehen sind:

(d) jeder Speicherblock umfaßt Speicher (30, 31; 40, 41), in denen ein numerischer Periodenwert To, der repräsentativ für die Periodendauer des Grundsignals des zu erzeugenden periodischen Signals ist, bzw. ein sich stufenweise ändernder numerischer Ereigniswert $T_E$ + To, $T_E$ + 2 To, . . . gespeichert ist,
(e) eine Zähleinrichtung (33; 50) gespeist von einem eine Festfrequenz erzeugenden Taktgeber (34; 51),
(f) eine Komparatoreinrichtung (35; 52; 62) zum Vergleichen eines ausgelesenen numerischen Ereigniswertes mit dem Zählstand t der Zähleinrichtung und zum Erzeugen eines Kommandosignales DIF, wenn der Zählstand der Zähleinrichtung die Größe dieses Ereigniswertes erreicht oder übersteigt,
(g) Einrichtungen (32; 47; 62) zum Addieren des gespeicherten Periodenwertes und des jeweils gespeicherten Ereigniswertes und zum Einspeichern des erhaltenen Resultats als nächsten Ereigniswert in den von dem der Addition zugrunde liegenden Ereigniswert belegten Speicherplatz bei Auftreten eines Kommandosignals DIF.

2. Syntheseschaltung nach Anspruch 1, dadurch gekennzeichnet, daß sie zusätzlich zweite Mittel zum Erzeugen von Kommandosignalen DIF aufweist, umfassend eine Gruppe von Generatoren (23, 24 . . . 29), Mittel (29) zum Auswählen eines der Generatoren entsprechend einer Kennziffer I, die aus einem Speicher (20) ausgelesen wird, und Mittel zum Erzeugen von Kommandosignalen DIF ausgehend von den Generatorsignalen, wobei Auswahlschaltkreise vorgesehen sind für die Abgabe der Kommandosignale DIF entweder von den ersten oder den zweiten Mitteln in Abhängigkeit von einem aus dem betreffenden Speicherblock ausgelesenen Auswahlparameter.

Syntheseschaltung nach Anspruch 1 oder 2, dadurch gekennzeichnet, daß sie Mittel zum automatischen Verändern des Periodenwertes To in Abhängigkeit von der Zeit umfaßt.

4. Syntheseschaltung nach einem der Ansprüche 1 bis 3, dadurch gekennzeichnet, daß die Komparatoreinrichtung (35) zum Vergleich des Ereigniswertes $T_E$, . . . mit dem Zählstand t einen Subtrahierschaltkreis umfaßt, an dessen Eingängen der Ereigniswert $T_E$ bzw. der Zählstand t anliegen, und der einen Ausgang aufweist, an dem ein dem Vorzeichen der Differenz beider Werte entsprechendes Kommandosignal DIF abgreifbar ist.

5. Syntheseschaltung nach einem der Ansprüche 1 bis 3, dadurch gekennzeichnet, daß die Zähleinrichtung (51) einen Abwärtszähler umfaßt und die Komparatoreinrichtung zum Vergleich des Ereigniswertes $T_E$ und des Zählstandes —t einen Addierschaltkreis umfaßt, an den die Werte $T_E$, . . .; —t anlegbar sind, und der eine das Vorzeichen der Summe —t + $T_E$ repräsentierende Ausgangsgröße als Kommandosignal DIF erzeugt.

6. Syntheseschaltung nach Anspruch 3, 4 oder 5, dadurch gekennzeichnet, daß jeder Speicherblock einen Speicher (42) für den Modulationskoeffizienten m einer Phasenmodulation des zu erzeugenden Signals und einen Speicher (43) für den numerischen Wert Rm der Modulationsoktavenkennzahl der Phasenmodulation umfaßt und daß die Schaltung ferner einerseits Addier-/ Subtrahierschaltkreise (45) aufweist, mit einem Steuereingang zum Umschalten zwischen Addition und Subtraktion, mit zwei Signaleingängen, denen der Modulationskoeffizient m bzw. ein die Periodendauer des Grundsignals repräsentierender Periodenwert $T'_0$, gebildet als Summe der Größe To und einer Konstante Ko, zugeführt werden, und mit einem Ausgang, an dem ein neuer Periodenwert T'o ± m abgreifbar und zu den Addiereinrichtungen (47, 62) übertragbar ist, sowie andererseits Mittel zum Erzeugen des periodischen Signals $\Delta$ aufweist, das an den Steuereingang anlegbar ist und dessen Folgefrequenz von der Modulationsoktavenkennzahl Rm abhängt.

7. Syntheseschaltung nach Anspruch 6, dadurch gekennzeichnet, daß die Mittel zum Erzeugen des periodischen Steuersignals $\Delta$ einen Multiplexschaltkreis (44) umfassen, mit einem Eingang für die numerischen Daten der Augenblicksphase $\varphi$ mit einem Auswahlsteuereingang zum Anlegen der Modulationsoktavenkennzahl Rm und einem Ausgang zum Erzeugen eines Steuersignals.

8. Syntheseschaltung nach einem der vorangehenden Ansprüche, gekennzeichnet durch

(h) eine Anzahl von Speicherblöcken (100), in denen numerische Daten des Periodenwertes T'o, des Ereigniswertes $T_E$, der Phasenkennzahl $\varphi$, des Amplitudenwertes AMP, der Oktavenkennzahl $R_m$, des Wellenformkennwertes F, des Modulationskoeffizienten m und der Modulationsoktavenkennzahl Rm gespeichert sind,

(i) ein erstes Register (7) zur zeitweiligen Speicherung von $T_E$ — oder Phasendaten,

(j) einen Wellenform-Abtastwertspeicher (8) mit Adressiereingängen zum Anlegen der Daten F der Wellenform, der Oktavenkennzahl R und der Phasenkennzahl $\varphi$, ausgelesen aus den Speicherblöcken,

(k) einen Multiplizierschaltkreis (9) zum Multiplizieren jedes numerischen Abtastwertes, der aus dem Abtastwertspeicher (8) entnommen wird, mit den aus den Speicherblöcken ausgelesenen Amplitudendaten AMP,

(l) einen Digital-/Analogumsetzer für die Abtastwerte aus dem Multiplizierschaltkreis (10) mit nachgeschaltetem Integrationsverstärker und Filterschaltungen (12, 15; 13, 14) für die analogen Abtastwerte,

(m) den Taktgeber (50) mit zugeordnetem Abwärtszähler (51) zum Erzeugen einer schrittweise variablen Zeitkennziffer —t,

(n) einen ersten Addierschaltkreis (62) zum Addieren der aus dem Block ausgelesenen numerischen Ereignisdaten $T_E$ zu den Zeitdaten —t und zum Erzeugen eines Kommandosignals DIF, wenn die sich ergebende Summe negativ ist,

(o) einen ersten Addier-/Subtrahierschaltkreis (45) zum Addieren bzw. Subtrahieren der Periodendaten T'o und der Modulationsdaten m in Abhängigkeit von einem Steuersignal $\Delta$,

(p) Mittel zum Erzeugen des Steuersignals $\Delta$ durch Auswahl eines Binärelementes der Phasenkennzahl $\varphi$ durch den Wert der Modulationsoktavenkennzahl Rm,

(q) einen zweiten Addierschaltkreis (46) zum Addieren einer Konstanten Ko zur Summe von Periodenwert und Modulationskoeffizienten T'o ± m und

(r) eine vom Abwärtszähler (51) gesteuerte Multiplexiereinrichtung (64) zum Anlegen der vom zweiten Addierschaltkreis (46) gelieferten Endsumme T'o ± m + Ko an den ersten Addierschaltkreis (62) zwecks Speichern der erhaltenen Summe $T_E$ + T'o ± m + Ko anstelle des Ereigniswertes $T_E$ in dem entsprechenden Block in Abhängigkeit von dem Kommandosignal DIF.

9. Syntheseschaltung nach Ansrpruch 8, dadurch gekennzeichnet, daß zwischen den Multiplizierschaltkreis (202) und den Digital-/Analogumsetzer (204) ein Zwischenspeicher (200) geschaltet ist, in den die vom Multiplizierschaltkreis (202) abgegebenen Signale unter Adressierung durch die Ereigniswerte $T_E$ einspeicherbar und unter Adressierung durch einen Taktgenerator (208) zeitverschoben auslesbar sind.

10. Syntheseschaltung nach Anspruch 9, dadurch gekennzeichnet, daß der Taktgenerator (208) zugleich als Taktgeber für die Mittel zur Erzeugung der Kommandosignale DIF dient.

11. Syntheseschaltung nach Anspruch 10, dadurch gekennzeichnet, daß dem Zwischenspeicher (200) eine Mehrzahl von parallelen Digital-/Analogwandler-Eingangskanäle nachgeschaltet ist, und daß die Einspeicheradresse einerseits, die Ausleseadresse andererseits eine Information bezüglich der anzusteuernden Eingangskanäle enthält.

12. Syntheseschaltung nach Anspruch 1, dadurch gekennzeichnet, daß die vom Taktgeber (34, 51) für die Zähleinrichtung (33, 50) erzeugte Taktfrequenz im Bereich von etwa 1 bis 2 MHz liegt.

13. Anwendung mindestens einer Syntheseschaltung nach einem oder mehreren der vorangehenden Ansprüche als Tonerzeugungsysstem eines Musikinstruments.

**Claims**

1. Polyphonic synthesizer circuit for periodic signals with

(a) a number of memory blocks with memories (1, 2 . . .) in which it is possible to store digital data at least of the instantaneous phase, of the octave and of the amplitude of analogue periodic signals to be produced,

(b) means of addressing and reading out the memory blocks according to a predetermined concatenation,

(c) means for producing analogue sample values of the analogue periodic signals from the data read ouit of the memory blocks depending upon command signals (DIF) of predetermined repetition frequency,

characterized in that the following means are provided for the production of the command signals:

(d) each memory block comprises memories (30, 31; 40, 41) in which a digital periodic value To, which is representative of the period duration of the basic signal of the periodic signal to be produced, or a stepwisely changing digital event value $T_E + $ To, $T_E + 2$ To is stored,

(e) a counting device (33; 50) fed by an oscillator (34; 51) producing a fixed frequency,

(f) a comparator device (35; 52; 62) to compare a digital event value read out with the counting level t of the counting device and to produce a command signal DIF when the counting level of the counting device reaches or exceeds the size of this event value,

(g) devices (31; 47, 62) for adding the stored periodic value and the event value stored in each instance, and for storing the result obtained as next event value into the storage area occupied by the event value as the basis of the addition on the occurrence of a DIF command signal.

2. Synthesizer circuit according to claim 1, characterized in that it comprises additionally two sets of means for the production of DIF command signals, comprising a group of generators (23, 24 ... 29), means (29) for the selection of a characteristic l corresponding to one of the generators, which characteristic is read out from a memory (20), and means for the production of command signals DIF starting from the generator signals, wherein selection circuits are provided for the delivery of the command signals DIF either from the first or from the second means depending upon a selection parameter read out of the appropriate memory block.

3. Synthesizer circuit according to claim 1 or 2, characterized in that it comprises means for the automatic modification of the periodic value To depending upon time.

4. Synthesizer circuit according to one of claims 1 to 3, characterized in that the comparator device (35), for the comparison of the event value $T_E$ ... wich the counting level t, comprises a substracting circuit to the inputs of which the event value $T_E$ and the counting level t are applied respectively, and which has an output at which a command signal corresponding to the sign of the difference of the two values can be obtained.

5. Synthesizer circuit according to one of claims 1 to 3, characterized in that the counting device (51) comprises a down counter, and the comparator device for the comparison of the event value $T_E$ and the counting level $-t$ comprises an adding circuit to which the values $T_E$, ...; $-t$ can be applied, and which produces an output value representing the sign of the sum $-t + T_E$ as command signal DIF.

6. Synthesizer circuit according to claim 3, 4 or 5, characterized in that each memory block comprises a memory (42) for the modulation coefficient m of a phase modulation of the signal to be produced and a memory (43) for the digital value Rm of the modulation octave characteristic of the phase modulation, and that the circuit comprises further, on the one hand, addition/substraction circuits (45) with a control input for switching between addition and subtraction, with two signal inputs to which the modulation coefficient m, and a periodic value $T'_0$ representing the period duration of the basic signal and formed as the sum of the value To and a constant Ko, are supplied respectively, and with an output from which a new periodic value $T'o \pm m$ can be obtained and be transferred to the addition devices (47, 62), as well as, on the other hand, means for the production of the periodic signal $\Delta$ which can be applied to the control input, and the repeat frequency of which is dependent upon the modulation octave code number Rm.

7. Synthesizer circuit according to claim 6, characterized in that the means for the production of the periodic control signal $\Delta$ comprise a multiplex circuit (44) with an input for the digital data of the instantaneous phase $\varphi$ with a selection control input for the application of the modulation octave code number Rm and an output for the production of a control signal.

8. Synthesizer circuit according to one of the foregoing claims, characterized by

(h) a number of memory blocks (100) in which digital data of the periodic value $T'o$, of the event value $T_E$, of the phase code number $\varphi$, of the amplitude value AMP, of the octave code number Rm, of the waveform characteristic F, of the modulation coefficient m and of the modulation octave code number Rm are stored,

(i) a first register (7) for the temporary storage of $T_E$ or phase data,

(j) a waveform sample value memory (8) with address inputs for the application of the data F of the waveform, of the octave code number R and of the phase code number $\varphi$, read from the memory blocks,

(k) a multiplier circuit (9) for the multiplication of each, digital sample value, which is taken from the sample value memory (8), by the amplitude data AMP read off the memory units,

(l) a digital/analogue converter for the sample value from the multiplier circuit (10) with subsequent integration amplifier and filter circuits (12, 15; 13, 14) for the analogue sample values,

(m) the oscillator (50) with associated down counter (51) for the production of a stepwise variable time code number $-t$,

(n) a first addition circuit (62) for the addition of the digital event data $T_E$ read off the unit to the time data $-t$, and for the production of a command signal DIF when the sum arrived at is negative,

(o) a first addition/substraction circuit (45) for adding or subtracting the periodic data T'o and the modulation data m depending upon a control signal $\Delta$,

(p) means for the production of the control signal $\Delta$ through the selection of a binary element of the phase code number $\varphi$ through the value of the modulation octave code number Rm,

(q) a second addition circuit (46) for adding a constant Ko to the sum of periodic value and modulation coefficient T'o $\pm$ m and

(r) a multiplexing device (64) controlled by the down counter (51) for the application of the end sum T'o $\pm$ m + Ko supplied by the second addition circuit (46) to the first addition circuit (62) for the storage of the sum $T_E$ + T'o $\pm$ m + Ko obtained instead of the event value $T_E$ in the corresponding block depending upon the command signal DIF.

9. Synthesizer circuit according to claim 8, characterized in that, between the multiplier circuit (202) and the digital/analogue converter (204) an intermediate store (200) is inserted into which the signals supplied from the multiplier circuit (202) with addressing by the event values $T_E$ can be stored, and which can be read off shifted in time with addressing by a timing generator (208).

10. Synthesizer circuit according to claim 9, characterized in that the timing generator (208) serves simultaneously as the oscillator for the means for the production of the command signal DIF.

11. Synthesizer circuit according to claim 10, characterized in that a plurality of parallel digital/analogue converter input channels are inserted in the circuit after the intermediate store (200), and in that the memory address on the one hand, the read-off address on the other hand, contain an information with regard to the selection of the input channels.

12. Synthesizer circuit according to claim 1, characterized in that the clock frequency produced by the oscillastor (34, 51) for the counting device (33, 50) lies within the range of about 1 to 2 MHz.

13. Application of at least one synthesizer circuit according to one or more of the foregoing claims as a music production system for a musical instrument.

**Revendications**

1. Circuit synthétiseur polyphonique de signaux périodiques, comprenant:

(a) un certain nombre de blocs de mémoire avec des mémoires (1, 2 . . .) dans lesquelles peuvent être mémorisées des données numériques, au moins de phase instantanée, d'octave et d'amplitude pour produire des signaux périodiques analogiques,

(b) des dispositifs d'adressage et de lecture des blocs de mémoire, selon un enchaînement prédéterminé,

(c) des dispositifs pour produire des valeurs analogiques d'analyse des signaux périodiques analogiques à une fréquence de répétition prédéterminée à partir de données lues dans les blocs de mémoire en fonction des signaux de commande (DIF),

caractérisé en ce que, pour la production des signaux de commande, les dispositions suivantes sont prises:

(d) chaque bloc de mémoire comprend des mémoires (30, 31; 40, 41) dans lesquelles est mémorisée une valeur numérique de période (To) qui représente la durée de la période du signal fondamental du signal périodique à produire, ou une valeur numérique d'évènement variant pas à pas ($T_E$ + To, $T_E$ + 2 To . . .)

(e) un dispositif de comptage (33; 50) alimenté par un émetteur d'impulsions (34, 51) produisant une fréquence fixe,

(f) un dispositif comparateur (35, 52, 62) pour comparer une valeur numérique d'évènement lu avec le comptage (t) du dispositif de comptage et pour produire un signal de commande (DIF) quand la valeur du comptage du dispositif de comptage atteint ou dépasse cette valeur d'évènement,

(g) des dispositifs (32, 47, 62) pour additionner les valeurs de périodes mémorisées et chacune des valeurs d'évènements mémorisées et pour écrire le résultat obtenu comme valeur d'évènement suivante dans la position de mémoire marquée avec le résultat d'évènement résultant de l'addition, à l'apparition d'un signal de commande (DIF).

2. Circuit synthétiseur selon la revendication 1, caractérisé en ce qu'il comporte deux dispositifs supplémentaires pour produire le signal de commande (DIF) comprenant un groupe de générateurs (23, 24 . . . 29), un dispositif (29) pour sélectionner l'un des générateurs correspondants à un indicatif (I) qui est lu dans une mémoire (20) et un dispositif pour produire le signal de commande (DIF) à partir des signaux du générateur, des circuits de sélection étant prévus pour produire le signal de commande (DIF) à partir du premier ou du second dispositifs en fonction d'un paramètre de sélection lu dans le bloc de mémoire considéré.

3. Circuit synthétiseur selon la revendication 1 ou 2, caractérisé en ce qu'il comporte un dispositif pour modifier automatiquement la valeur de période (To) en fonction du temps.

4. Circuit synthétiseur selon l'une des revendications 1 à 3, caractérisé en ce que le dispositif comparateur (35) destiné à comparer les valeurs d'évènements ($T_E$ . . .) avec le comptage (t) comporte un circuit soustracteur aux entrée duquel sont appliqués la valeur d'évènements ($T_F$) et le

comptage (t), et qui comporte une sortie à laquelle peut être prélevé un signal de commande (DIF) correspondant au signe de la différence entre les deux valeurs.

5. Circuit synthétiseur selon l'une des revendications 1 à 3, caractérisé en ce que le dispositif de comptage (51) comporte un décompteur et que le dispositif comparateur destiné à comparer la valeur d'évènement ($T_E$) et le comptage ($-t$) comporte un dispositif additionneur auquel sont appliquées les valeurs ($T_E \dots -t$) et qui produit comme signal de commande (DIF) une valeur de sortie représentant le signe de la somme ($-t + T_E$).

6. Circuit synthétiseur selon la revendication 3, 4 ou 5, caractérisé en ce que chaque bloc de mémoire comporte une mémoire (42) pour les coefficients de modulation (m) d'une modulation de phase des signaux à produire et une mémoire (43) pour la valeur numérique (Rm) de l'indicateur d'octaves de modulation de phase, et que le circuit comporte en outre, d'une part un circuit additionneur/soustracteur (45) avec une entrée de commande pour passer entre l'addition et la soustraction, avec deux entrées de signaux auxquels sont appliqués le coefficient de modulation (m) et une durée de période de la valeur de période ($T'_0$) représentant la durée de la période du signal fondamental, formé comme une somme de la valeur (To) et d'une constante (Ko), et avec une sortie à laquelle peut être prélevée une nouvelle valeur de période ($T'o \pm m$) et pour la transmettre au dispositif additionneur (47, 62) et d'autre part un dispositif pour produire un signal périodique ($\varDelta$) qui peut être appliqué à l'entrée de commande et dont la fréquence de répétition dépend de l'indicateur d'octaves de modulation (Rm).

7. Circuit synthétiseur selon la revendication 6, caractérisé en ce que le dispositif de production du signal de commande périodique ($\varDelta$) comporte un circuit multiplexeur (44) avec une entrée pour les données numériques de la phase instantanée $\varphi$ avec une entrée de commande de sélection pour l'application de l'indicateur d'octave de modulation (Rm) et une sortie pour produire un signal de commande.

8. Circuit synthétiseur selon l'une quelconque des revendications précédentes, caractérisé en ce qu'il comporte:

(h) un certain nombre de blocs de mémoire (100) dans lesquels sont mémorisées des données numériques de valeur de période ($T'o$), de valeur d'évènement ($T_E$), d'indicateur de phase ($\varphi$), de valeur d'amplitude (AMP), d'indicateur d'octave (Rm), de valeur de formes d'ondes (F), de coefficient de modulation (m) et d'indicateur d'octave de modulation (m),

(i) un premier registre (7) pour la mémorisation momentanée de ($T_E$) ou des données de phase,

(j) une mémoire de valeurs d'analyse de formes d'ondes (8) avec des entrées d'adressage pour appliquer les données (F) de forme d'ondes, l'indicateur d'octaves (R) et l'indicateur de phase ($\varphi$), lus dans les blocs de mémoire,

(k) un circuit multiplicateur (9) destiné à multiplier chaque valeur numérique d'analyse qui est extraite de la mémoire de valeur d'analyse (8) avec des données d'amplitude (AMP) lues dans les blocs de mémoire,

(l) un convertisseur numérique-analogique pour les valeurs d'analyse provenant du circuit multiplicateur (10) suivi par un amplificateur d'intégration et des circuits de filtre (12, 15; 13, 14) pour les valeurs analogiques d'analyse,

(m) un émetteur d'impulsions (50) avec un décompteur (51) associé pour produire un indicateur de temps ($-t$) variable pas à pas,

(n) un premier circuit additionneur (62) destiné à additionner les données numériques d'évènements ($T_E$) lues dans le bloc aux données de temps ($-t$) et pour produire un signal de commande (DIF) quand la somme produite est négative,

(o) un premier circuit additionneur/soustracteur (45) destiné à additionner et à soustraire les données de période ($T'o$) et les données de modulation (m) en fonction d'un signal de commande ($\varDelta$),

(p) un dispositif de production du signal de commande ($\varDelta$) par la sélection d'un élément binaire de l'indicateur de phase ($\varphi$), par la valeur de l'indicateur d'octave de modulation (Rm),

(q) un second circuit additionneur (46) pour additionner une constante (Ko) à la somme de la valeur de période et du coefficient de modulation ($T'o \pm m$) et

(r) un dispositif multiplexeur (64) commandé par un décompteur (51) pour appliquer la somme finale ($T'o \pm m + Ko$) délivré par le second circuit additionneur (46) au premier circuit additionneur (62) en vue de la mémorisation de la somme obtenue ($T_E + T'o \pm m + Ko$) à la place de la valeur d'évènement ($T_E$) dans le bloc correspondant en fonction du signal de commande (DIF).

9. Circuit synthétiseur selon la revendication 8, caractérisé en ce que, entre le circuit multiplicateur (202) et le convertisseur numérique-analogique (204) est connectée une mémoire intermédiaire (200) dans laquelle peuvent être mémorisés les signaux délivrés par le circuit multiplicateur (202) et peuvent être lus avec un décalage de temps par l'adressage par un générateur d'impulsions (208).

10. Circuit synthétiseur selon la revendication 9, caractérisé en ce que le générateur d'impulsions (208) sert en même temps d'émetteur d'impulsions pour le dispositif de production du signal de commande (DIF).

11. Circuit synthétiseur selon la revendication 10, caractérisé en ce que la mémoire intermédiaire (200) est connectée à plusieurs canaux d'entrée de convertisseur numérique-analogique en parallèle et que l'adresse d'écriture d'une part, et l'adresse de lecture d'autre part, contiennent une information concernant les canaux d'entrée à commander.

12. Circuit synthétiseur selon la revendication 1, caractérisé en ce que la fréquence des impulsions produites par l'émetteur d'impulsions (34, 51) pour le dispositif de comptage (33, 50) se situe dans la plage de 1 à 2 MHz.

13. Application d'au moins un circuit synthétiseur selon l'une ou plusieurs des revendications précédentes comme système de production de son d'un instrument de musique.

Fig.1

Fig.2

Fig.3

Fig. 4

Fig.5

Fig.6